# FASCICULE DE BREVET EUROPEEN

(11) **EP 2 628 185 B1**
(45) Date de publication et mention de la délivrance du brevet: **27.05.2015**
(21) Numéro de dépôt: 11776554.5
(22) Date de dépôt: 07.10.2011
(51) Int. Cl.: H01L 29/778

(54) **HÉTÉROSTRUCTURE SEMI-CONDUCTRICE ET TRANSISTOR DE TYPE HEMT, EN PARTICULIER POUR APPLICATIONS CRYOGÉNIQUES A BAS BRUIT ET A BASSE FRÉQUENCE**
HALBLEITERHETEROSTRUKTUR UND HEMT-TRANSISTOR, INSBESONDERE FÜR NIEDERFREQUENTE RAUSCHARMER KRYOGENE ANWENDUNGEN
SEMICONDUCTOR HETEROSTRUCTURE AND TRANSISTOR OF HEMT TYPE, IN PARTICULAR FOR LOW-FREQUENCY LOW-NOISE CRYOGENIC APPLICATIONS.

(30) Priorité: 11.10.2010 FR 1004012
(43) Date de publication de la demande: 21.08.2013
(73) Titulaire: Centre National de la Recherche Scientifique, 75016 Paris (FR)
(72) Inventeur: JIN, Yong, F-94260 Fresnes (FR); GENNSER, Ulf, F-75007 Paris (FR); CAVANNA, Antonella, F-91700 Villiers Sur Orge (FR)
(74) Mandataire: Corret, Hélène
(86) Numéro de dépôt international: PCT/IB2011/054432
(87) Numéro de publication internationale: WO 2012/049603

(56) Documents cités:
- US-A- 5 404 032
- US-A- 5 449 928
- US-A- 6 100 542
- US-A- 6 160 274
- BROWN J J ET AL: "InP-based HEMTs with AlIn1-xP Schottky barrier layers grown by gas-source MBE", PROCEEDINGS OF THE INTERNATIONAL CONFERENCE ON INDIUM PHOSPHIDE AND RELATED MATERIALS. SANTA BARBARA, MAR. 27 - 31, 1994; [PROCEEDINGS OF THE INTERNATIONAL CONFERENCE ON INDIUM PHOSPHIDE AND RELATED MATERIALS], NEW YORK, IEEE, US, vol. CONF. 6, 27 mars 1994 (1994-03-27), pages 419-422, XP010118989, DOI: DOI:10.1109/ICIPRM.1994.328259 ISBN: 978-0-7803-1476-4
- TANABE M ET AL: "THE IMPACT OF USING ALGAAS AS A CARRIER SUPPLYING LAYER IN AN INALAS/INGAAS HIGH ELECTRON MOBILITY TRANSISTOR STRUCTURE ON THERMAL STABILITY", APPLIED PHYSICS LETTERS, AIP, AMERICAN INSTITUTE OF PHYSICS, MELVILLE, NY, US, vol. 70, no. 25, 23 juin 1997 (1997-06-23) , pages 3386-3388, XP000658885, ISSN: 0003-6951, DOI: DOI:10.1063/1.119179

## Description

L'invention porte sur un transistor à effet de champ à haute mobilité électronique (HEMT, de l'anglais « *High Electron Mobility Transistor*») destiné en particulier - mais pas exclusivement - à être utilisé à des températures cryogéniques, à bas bruit et à basse fréquence. L'invention porte également sur une hétérostructure à partir de laquelle peut être réalisé un tel transistor.

Le transistor à effet de champ à jonction (JFET, de l'anglais « *Junction Field Effect Transistor* ») en silicium (Si) est le composant de choix pour toutes les applications qui nécessitent une haute impédance d'entrée et un faible niveau de bruit dans le domaine des basses fréquences. Typiquement, son niveau du bruit équivalent d'entrée est d'environ 1 nV/√Hz à 1 kHz. Cependant, les JFET ne peuvent pas fonctionner à des températures cryogéniques, inférieures à 40K environ, et au-dessous de 100K environ on observe une nette dégradation de leurs performances en termes de transconductance et de niveau de bruit. Voir à ce propos l'article de F. Ayela et al. « Noise measurements on silicon J-FETs at low temperature using a very high Q superconducting resonator», Rev. Sci. Instrum. 62 (11), novembre 1991, pages 2816 - 2821.

Le couplage entre un détecteur refroidi à température cryogénique et son électronique d'acquisition à JFET doit donc se faire par l'intermédiaire d'un câble qui introduit des bruits supplémentaires et dont la capacité réduit la vitesse d'acquisition.

Les JFET et MESFET (transistors à effet de champ métal-semiconducteur, de l'anglais « *MEtal-Semiconductor Field Effect Transistor* ») en GaAs constituent une alternative aux JFET en silicium pour les applications cryogéniques. Les performances de ces composants sont décrites par l'article de R. K. Kirschman et J. A. Lipa « Further evaluation of GaAs FETs for cryogenic readout ». Leur niveau de bruit à basse fréquence est typiquement plus élevé que celui des JFET en Si.

Les transistors à effet de champ à haute mobilité électronique (HEMT) peuvent fonctionner aussi bien à température ambiante qu'à basse température. Ces dispositifs ont d'excellentes performances dans le domaine des hyperfréquences, mais ils présentent un niveau de bruit relativement important à des fréquences inférieures à 1 GHz environ. Voir à ce propos :
- R. Plana et al. «Noise in AlGaAs/InGaAs/GaAs Pseudomorphic HEMT's from 10 Hz to 18 GHz », IEEE Transactions on Electron Devices, Vol. 40, No 5, mai 1993 ; et
- E. Grémion et al. «Development of Ultra-Low Noise HEMTs for Cryoelectronics at ≤ 4.2K », J. Low Temp. Phys. (2008) 151, pages 971 - 978.

En outre, leur courant de fuite de grille est bien supérieur à celui des JFET. Plusieurs solutions alternatives ont été proposées pour réduire le courant de grille des HEMT ; voir à ce propos les articles suivants:
- S. Mizuno et al. « Large Gate Leakage Current in AlGaN/GaN High Electron Mobility Transistors », Jpn. J. Appl. Phys. Vol. 41 (2002), pages 5125 - 5126 ;
- H. C. Lin et al. « Enhancement-mode GaAs metal-oxide-semiconductor high-electron-mobility transistors with atomic layer deposited Al2O3 as gate dielectric », Applied Physics Letters 91, 212101 (2007); et
- A. Nagayama et al. « Suppression of Gate Leakage Current in n-AlGaAs Power HEMTs », IEEE Transactions on Electron Devices, Vol. 47, No 3, mars 2000.
- J.J. Brown et al. "InP-Based HEMTs with AlxIn1-xP Schottky Barrier Layers Grown by Gas-Source MBE", Proceedings of the International Conference on Indium Phosphide and Related Materials, 27-31 March 1994, New York, IEEE, pages 419-422.

La mise en oeuvre de ces solutions s'avère complexe et ne permet pas d'atteindre un niveau de bruit aussi bas que celui des JFET en Silicium.

L'invention vise à surmonter les inconvénients précités de l'art antérieur et plus particulièrement à permettre la réalisation de transistors présentant une haute impédance, un faible courant de fuite de grille et un faible niveau de bruit à basse fréquence, et susceptibles de fonctionner à des températures cryogéniques.

Un premier objet de l'invention est une hétérostructure pouvant servir d'élément de base pour la réalisation d'un tel transistor.

Une hétérostructure semi-conductrice selon l'invention comprend :
- un substrat ;
- une couche tampon déposée sur ou au-dessus dudit substrat ;
- une couche d'espacement déposée sur ou au-dessus de ladite couche tampon ; et
- une couche barrière déposée sur ladite couche d'espacement ;
   dans cette hétérostructure :
- un dopage est prévu dans la couche barrière, ou à l'interface entre la couche d'espacement et la couche barrière ; et
- lesdites couches barrière et d'espacement sont réalisées en un ou plusieurs matériaux semi-conducteur présentant une bande interdite plus large que le ou les matériaux constituant ladite couche tampon ;
   l'hétérostructure étant caractérisé en ce que :
- ladite couche barrière comprend une première sous-couche barrière, en contact avec ladite couche d'espacement, et une deuxième sous-couche barrière, éloignée de ladite couche d'espacement; et en ce que
- ladite deuxième sous-couche barrière présente une bande interdite plus large que ladite première sous-couche barrière.
- Ladite couche barrière peut être réalisée en un matériau semi-conducteur contenant de l'Aluminium, ladite deuxième sous-couche barrière présentant une teneur en aluminium plus élevée que ladite première sous-couche barrière. En particulier, elle peut être réalisée en AlₓGa₁₋ₓAs avec un coefficient stoechiométrique x ayant: dans ladite première sous-couche barrière, une valeur comprise entre 0,18 et 0,33; et dans ladite deuxième sous-couche barrière, une valeur comprise entre 0,35 et 0,5. De préférence, le coefficient stoechiométrique x de ladite deuxième sous-couche barrière peut avoir une valeur comprise entre 0,38 et 0,42.
- Ladite première sous-couche barrière peut présenter une épaisseur comprise entre 3 nm et 10 nm et ladite deuxième sous-couche barrière une épaisseur comprise entre 3 nm et 50 nm.
- Ladite couche d'espacement comprend une première sous-couche d'espacement, en contact avec ladite couche barrière, une deuxième sous-couche d'espacement déposée sur ou au-dessus de ladite première sous-couche et une troisième sous-couche d'espacement déposée sur ou au-dessus de ladite deuxième sous-couche ; et ladite deuxième sous-couche d'espacement présente une bande interdite plus large que lesdites première et troisième sous-couches d'espacement. Plus particulièrement, ladite couche d'espacement peut être réalisée en AlₓGa₁₋ₓAs, le coefficient stoechiométrique x ayant : dans lesdites première et troisième sous-couches d'espacement, une valeur comprise entre 0,18 et 0,33 ; et dans ladite deuxième sous-couche d'espacement, une valeur comprise entre 0,35 et 0,5. De préférence, le coefficient stoechiométrique x de ladite deuxième sous-couche d'espacement peut avoir une valeur comprise entre 0,38 et 0,42. Dans un mode de réalisation particulièrement avantageux, ladite première sous-couche barrière peut présenter une épaisseur comprise entre 3 nm et 15 nm, ladite deuxième sous-couche barrière une épaisseur comprise entre 1 nm et 50 nm et ladite troisième sous-couche barrière présenter une épaisseur comprise entre 3 nm et 10 nm.
- L'hétérostructure de l'invention peut comporter également, entre lesdites couches tampon et d'espacement, une couche épitaxiale réalisée en un matériau semi-conducteur de bande interdite moins large. En particulier, cette couche épitaxiale peut être réalisée en In_{y}Ga_{1-y}As, le coefficient stoechiométrique y prenant une valeur comprise entre 0,10 et 0,30. Avantageusement, ladite couche épitaxiale peut présenter une épaisseur comprise entre 1 et 20 nm.
- L'hétérostructure peut comprendre aussi une couche de recouvrement déposée sur ou au-dessus de ladite couche barrière.
- Ladite couche tampon et/ou ladite couche de recouvrement et/ou ledit substrat peuvent être en GaAs.
- Le dopage peut être de type N, et en peut se présenter sous la forme d'un plan de dopage, être réalisé en Si et avoir une concentration comprise entre 1.10¹² cm⁻² et 5·10¹³ cm⁻².

Un deuxième objet de l'invention est un transistor de type HEMT réalisé à partir d'une hétérostructure telle que décrite ci-dessus. Avantageusement, un tel transistor peut avoir un contact de grille de longueur comprise entre 1 et 100 µm et de largeur comprise entre 100 µm et 10 mm.

Un troisième objet de l'invention est l'utilisation d'un tel transistor à une température cryogénique, c'est à dire inférieure ou égale à 100K, de préférence inférieure ou égale à 77K (température d'ébullition de l'azote liquide à 1 atmosphère) et de manière encore préférée inférieure ou égale à 4,2 K (température d'ébullition de l'hélium liquide).

D'autres caractéristiques, détails et avantages de l'invention ressortiront à la lecture de la description faite en référence aux dessins annexés donnés à titre d'exemple et qui représentent, respectivement :
- La figure 1, la structure et la structure de bande d'une hétérostructure et d'un transistor de type HEMT selon l'art antérieur ;
- La figure 2, la structure et la structure de bande d'une hétérostructure et d'un transistor de type HEMT selon un mode de réalisation de l'invention ;
- La figure 3, la configuration d'électrodes d'un transistor de type HEMT selon un mode de réalisation de l'invention ;
- Les figures 4A - 4D et 5, l'influence de la géométrie de grille sur le bruit équivalent d'entrée dans un transistor.de type HEMT selon un mode de réalisation de l'invention.

Les transistors de type HEMT se basent sur un gaz bidimensionnel d'électrons («2DEG» de l'anglais « *2-Dimensional Electron Gaz* ») confiné dans un puits de potentiel formé dans une hétérostructure, à l'interface entre deux matériaux semi-conducteurs présentant des bandes interdites de largeurs différentes. Les électrons du gaz sont espacés des donneurs dont ils proviennent par une couche de matériau semi-conducteur à large bande interdite, ce qui leur assure une mobilité élevée. Ils se trouvent dans un état dégénéré, et leur comportement est quasiment indépendant de la température.

Les transistors HEMT les plus courants sont de type AsGa/AlₓGa₁₋ₓAs, où AsGa constitue le semi-conducteur à « petite » bande interdite et AlₓGa₁₋ₓAs le semi-conducteur à « grande » bande interdite. Plus la teneur en Al, exprimée par le paramètre « x », est élevée, plus la bande interdite du AlₓGa₁₋ₓAs est large, ce qui réduit le courant de fuite de la grille du transistor ; on observe également une diminution du niveau de bruit lorsque la valeur de « x » augmente. Mais une concentration excessive d'Al induit l'apparition de centres DX, qui capturent les électrons et constituent ainsi une source de bruit 1/f. Les centres DX commencent à apparaître dès que x dépasse une valeur de 0,2 ; le meilleur compromis entre efficacité d'ionisation des atomes donneurs (généralement Si), efficacité de leur transfert à l'interface AlₓGa₁₋ₓAs/AsGa et leur piégeage à basse température est atteint pour x≅0,33.

D'autres matériaux semi-conducteurs peuvent être utilisés pour la réalisation de HEMT. On peut citer, à titre d'exemple, le système GaN/AlₓGa₁₋ₓN dans lequel, aussi, Al permet d'élargir la bande interdite, mais a également l'effet collatéral d'engendrer des centres DX.

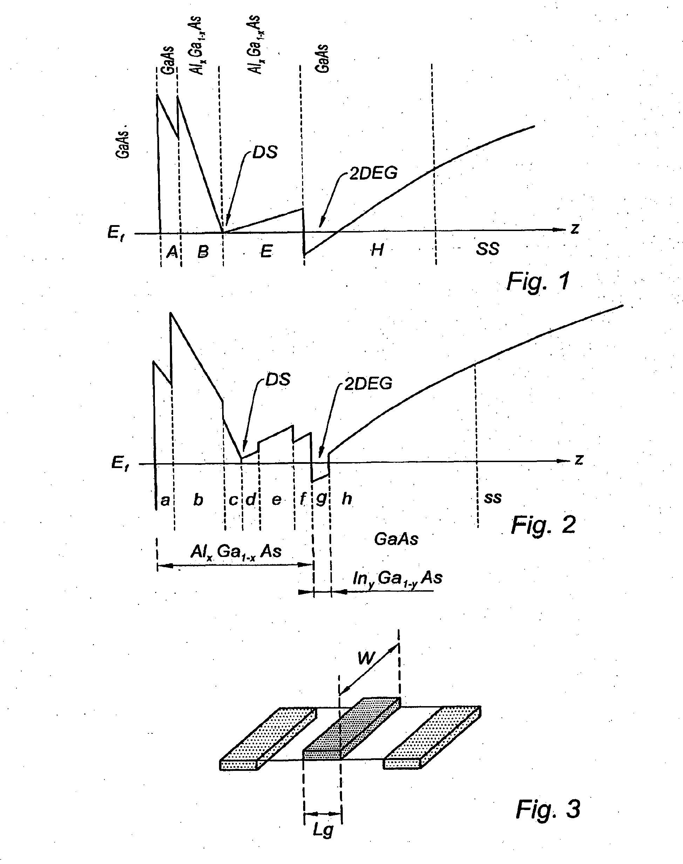

La figure 1 (qui n'est pas à l'échelle) illustre à la fois la structure et la structure de bandes (plus exactement, l'allure de la bande de conduction) d'une hétérostructure permettant la réalisation d'un HEMT selon l'art antérieur. La figure 1 est un graphique dans lequel l'axe des abscisses est une coordonnée spatiale (axe z, perpendiculaire au dispositif qui a une structure planaire) et l'axe des ordonnées représente l'énergie de la bande de conduction ; E_{f} représente l'énergie de Fermi.

L'hétérostructure comprend, à partir du bas :
- un substrat SS semi-isolant, par exemple en GaAs intrinsèque ;
- une couche épitaxiale « tampon » H, également en GaAs intrinsèque ;
- une couche « d'espacement » E, en AlₓGa₁₋ₓAs intrinsèque avec x compris entre 0,18 et 0,33 ;
- un plan de dopage DS (ou « dopage δ ») de type N, en Si;
- une couche « barrière » B, également en AlₓGa₁₋ₓAs intrinsèque avec x compris entré 0,18 et 0,33 ; et
- une couche de recouvrement, ou «cap layer »; A en GaAs, intrinsèque ou dopé, dont la fonction est de protéger de l'oxydation les couches sous-jacentes contenant de l'Aluminium.

La couche tampon présente une épaisseur de l'ordre du micromètre, les couches d'espacement et barrière de quelques dizaines de nanomètres et la couche de recouvrement de quelque nanomètrés. Les électrons issus des atomes donneurs de Si migrent vers l'interface entre la couche tampon et la couche d'espacement, où ils forment un gaz bidimensionnel indiqué par la référence 2DEG.

La figure 2 (qui n'est pas à l'échelle) représente, de la même manière, la structure et la structure de bandes d'une hétérostructure permettant la réalisation d'un HEMT selon un mode de réalisation de l'invention.
- Cette hétérostructure comprend, à partir du bas :
- un substrat SS semi-isolant, par exemple en GaAs intrinsèque ;
- une couche épitaxiale « tampon » h, également en GaAs intrinsèque;
- une couche épitaxiale g en In_{y}Ga_{1-y}As, avec 0,10≤y≤0,30, d'épaisseur comprise entre 1 et 20 nm ;
- une couche d'espacement formée de trois sous-couches en AlₓGa₁₋ₓAs:
   - une première sous-couche f, d'épaisseur comprise entre 3 et 15 nm, dans laquelle 0,18≤x≤0,33 ;
   - une deuxième sous-couche e, d'épaisseur comprise entre 1 et 50 nm, dans laquelle 0,35≤x≤0,50 ; et
   - une troisième sous-couche d, d'épaisseur comprise entre 3 et 10 nm, dans laquelle 0,18≤x≤0,33 ;
- un plan de dopage DS de type N, en Si avec une concentration comprise entre 1·10¹² cm⁻² et 5·10¹³ cm⁻² ;
- une couche barrière formée de deux sous-couches en AlₓGa₁₋ₓAs :
   - une première sous-couche c, d'épaisseur comprise entre 3 et 10 nm, dans laquelle 0,18≤x≤0,33 ; et
   - une deuxième sous-couche b, d'épaisseur comprise entre 3 et 50 nm, dans laquelle 0,35≤x≤0,50 et
- une couche de recouvrement, ou « cap layer » en GaAs.

La deuxième sous-couche barrière, b, présente une teneur en Al plus élevée que les couches barrières des dispositifs conventionnels. De ce fait, elle a une bande interdite plus large, ce qui limite le courant de fuite de la grille du transistor. En même temps, elle est séparée des atomes donneurs par la première sous-couche c, ce qui évite le piégeage des électrons par les nombreux centres DX en son sein.

De même, la deuxième sous-couche d'espacement, e, présente une teneur en Al plus élevée que les couches d'espacement des dispositifs conventionnels. De ce fait, elle a une bande interdite plus large, ce qui limite le courant dé fuite de la grille du transistor. En même temps, elle est séparée des atomes donneurs par la troisième sous-couche d et du gaz bidimensionnel d'électrons par la première sous-couche f, ce qui évite le piégeage des électrons par les nombreux centres DX en son sein.

La couche g, à bande interdite plus étroite que le GaAs, contribue au confinement des électrons.

De préférence, le coefficient stoechiométrique x a une valeur comprise entre 0,38 et 0,42 dans les sous-couches b et e. En effet, la bande interdite du AlₓGa₁₋ₓXAs a une largeur maximale pour x≈0,4.

Plusieurs variantes de l'invention peuvent être envisagées. En particulier, la couche g peut être omise. Par ailleurs, le principe de l'invention peut s'appliquer à des matériaux semi-conducteurs autres que le système AlₓGa₁₋ₓAs/GaAs, comme par exemple GaN/AlₓGa₁₋ₓN. L'utilisation d'un plan de dopage (ou « dopage de type δ ») n'est pas essentielle, mais permet d'obtenir des transistors HEMT avec une plus grande transconductance en réduisant la distance entre la grille et lé gaz bidimensionnel de porteurs. D'autres dopants que le Silicium peuvent être utilisés ; un dopage P est aussi possible, en principe, mais il conduirait à des transistors présentant des performances électroniques moins bonnes en raison de la mobilité réduite des trous. Par ailleurs, l'hétérostructure peut être plus complexe que celle illustrée par la figure 2, et comprendre des couches ou sous-couches supplémentaires.

Le transistor de l'invention est particulièrement adapté à des applications cryogéniques, à des températures inférieures ou égales à 100 K et de préférence inférieures ou égales à 77 K (température d'ébullition de l'azote liquide). Mais cela n'est pas une limitation essentielle, et le dispositif peut également trouver des applications à des températures plus élevées.

Un HEMT peut être réalisé sur l'hétérostructure de la figure 2 en déposant une électrode de source S et une électrode de drain D sur la couche de recouvrement, de manière à former des contacts ôhmiques, et une électrode de grille G directement sur la couche barrière, de manière à former un contact Schottky. Cette configuration est illustrée sur la figure 3. Il a été trouvé que les dimensions de l'électrode de grille, de forme généralement rectangulaire, ont une grande influence sur le niveau de bruit du dispositif ; en particulier, l'utilisation d'une électrode de surface relativement grande permet de minimiser l'effet des fluctuations statistiques à l'origine du bruit. Les meilleurs résultats sont obtenus en prenant une largeur de grille W comprise entre 100 µm et 10 mm et une longueur de grille Lg comprise entre 1 µm et 100 µm.

Un dispositif selon un mode de réalisation particulier de l'invention présente la structure suivante :
- Substrat en GaAs semi-isolant ;
- Couche tampon en GaAs, épaisseur 1 µm ;
- Pas de couche g ;
- Couche d'espacement homogène, en Al_{0,33}Ga_{0.67}As, épaisseur 20 nm ;
- Plan de dopage en Si, concentration 1,9·10¹³ cm⁻² ;
- Couche barrière composée d'une première sous-couche en Al_{0,33}Ga_{0.67}As, épaisseur 5 nm et d'une deuxième sous-couche en Al_{0,40}Ga_{0.60}As, épaisseur 10 nm ;
- Couche de recouvrement en GaAs, épaisseur 6 nm ;
- Lg=8 µm, W=2 mm.

Ses caractéristiques électronique à 4,2 K et avec une tension drain-source V_{ds}=0,1V, une tension grille-source V_{gs}=-0,18V et un courant drain-source I_{ds}=1mA sont :
- Courant de fuite de grille I_{gs} inférieure à 0,1 pA ;
- Puissance dissipée dans le transistor : 100 µW ;
- Transconductance gₘ : 50 mS ;
- Conductance de sortie g_{d} : 2,1 mS ;
- Capacité de grille-source C_{gs} : 23 pF ;
- Capacité de grille-drain C_{gd} : 3,3 pF ;
- Gain en tension : 10,7 avec une résistance de charge de 301 Ω ;
- Niveau de bruit équivalent d'entrée en tension: 0,9 nV/√Hz à 1 kHz ;
- Fréquence à laquelle le niveau de bruit 1/f est égale à celui du bruit blanc : 48 kHz ;
- Fréquence de coupure en courant fₜ= gₘ/(2πC_{gs}) : 0,4 GHz ;
- Fréquence de coupure RC avec impédance de source Rₛ=10 kΩ, f_{c}=1/(2πRₛC_{gs})=0,69 MHz.

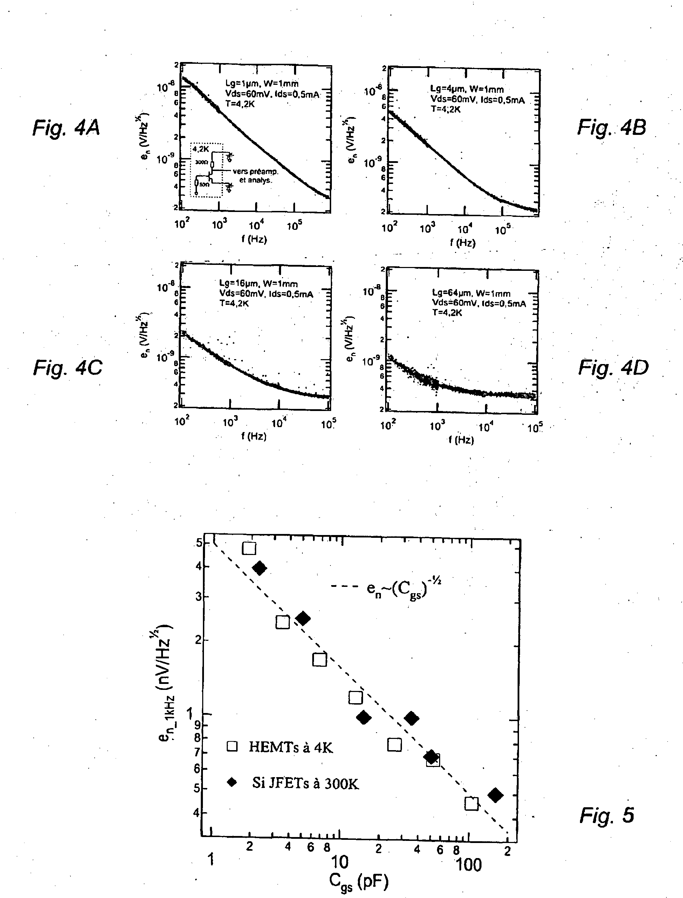

Les figures 4A - 4D montrent les spectres de bruit (tension de bruit équivalent d'entrée, en, exprimée en fonction de la fréquence f) pour quatre transistors présentant le structure décrite ci-dessus, mais avec des grilles de longueurs Lg différentes : 1µm pour la figure 4A, 4 µm pour la figure 4B ; 16 µm pour la figure 4C et 64 µm pour la figure 4D ; la largeur de grille W est égale à 1 mm dans tous les cas. Les spectres correspondent au point de travail suivant : tension drain-source V_{ds}=60 mV ; courant drain source I_{ds}=0,5 mA, à une température de 4,2K avec une résistance d'entrée de 50Ω et une résistance de charge de 300Ω. Le courant de fuite de grille reste inférieur à 1 pA dans tous les cas.

Sur les figures, les points correspondent aux résultats expérimentaux, obtenus en amplifiant la tension de bruit de sortie par un préamplificateur à très bas bruit, en l'analysant avec un analyseur de spectre dynamique et en en déduisant la tension équivalente d'entrée. Les courbes continues correspondent à une interpolation sur la base d'un modèle de bruit blanc superposé à un bruit 1/f.

On peut observer que le bruit à basse fréquence (au-dessous de 1kHz) diminue lorsqu'on augmente la surface de grille et descend au-dessous de 1 nV/√Hz à 1 kHz pour des surfaces de grille au-delà de 16µmx1mm.

La capacité de grille C_{gs} a été mesurée par détermination de la fréquence de coupure elle est pratiquement indépendante de V_{gs} et vaut : 1,9 pf pour Lg=1 µm ; 6,8 pF pour Lg=4µm ; 26 pF pour Lg=16 µm ; 105 pF pir Lg=64 µm. La figure 5, à l'échelle bi-logarithmique, montre la relation existante entre e_{n-1kHz} (niveau de bruit équivalent d'entrée en tension à 1 kHz) et C_{gs}; la ligne droite correspond à une proportionnalité e_{n-1kHz}°c1/√ C_{gs}. Les carrés blancs correspondent à des dispositifs selon l'invention ; on peut vérifier que leurs performances en termes de bruit sont au moins aussi bonnes que celles des JFET en silicium à 300K (losanges noires correspondant, de la gauche vers la droite, aux références suivantes de la société InterFET : NJ14AL; NJ26L; NJ132L; NJ450L; NJ903Let NJ1800DL).

## Revendications

1. Hétérostructure semi-conductrice comprenant :
- un substrat (SS) ;
- une couche tampon (h) déposée sur ou au-dessus dudit substrat ;
- une couche d'espacement (d, e, f) déposée sur ou au-dessus dé ladite couche tampon ; et
- une couche barrière (b, c) déposée sur ladite couche d'espacement ;
dans laquelle :
- un dopage (DS) est prévu dans la couche barrière, ou à l'interface entre la couche d'espacement et la couche barrière ; et
- lesdites couches barrière et d'espacement sont réalisées en un ou plusieurs matériaux semi-conducteur présentant une bande interdite plus large que le ou les matériaux constituant ladite couché tampon ;
- ladite couche barrière comprend une première sous-couche barrière (c), en contact avec ladite couche d'espacement, et une deuxième sous-couche barrière (b), éloignée de ladite couche d'espacement ;
- ladite deuxième sous-couche barrière (b) présente une bande interdite plus large que ladite première sous-couche barrière (c) ;
**caractérisé en ce que** :
- ladite couche d'espacement comprend une première sous-couche d'espacement (f), une deuxième sous-couche d'espacement (e) déposée sur ou au-dessus de ladite première sous-couche et une troisième sous-couche d'espacement (d) déposée sur ou au-dessus de ladite deuxième sous-couche **et en contact avec ladite couche barrière** ; et
- ladite deuxième sous-couche d'espacement (e) présente une bande interdite plus large que lesdites première (f) et troisième (d) sous-couches d'espacement.

2. Hétérostructure semi-conductrice selon la revendication 1, dans laquelle ladite couche barrière est réalisée en un matériau semi-conducteur contenant de l'Aluminium, ladite deuxième sous-couche barrière présentant une teneur en Aluminium plus élevée que ladite première sous-couche barrière.

3. Hétérostructure semi-conductrice selon l'une des revendications précédentes, dans laquelle ladite couche barrière est réalisée en AlₓGa₁₋ₓAs et dans laquelle le coefficient stoechiométrique x a :
- dans ladite première sous-couche barrière, une valeur comprise entre 0,18 et 0,33 ; et
- dans ladite deuxième sous-couche barrière, une valeur comprise entre 0,35 et 0,5 et de préférence entre 0,38 et 0,42.

4. Hétérostructure semi-conductrice selon l'une des revendications précédentes, dans laquelle ladite première sous-couche barrière présente une épaisseur comprise entre 3 nm et 10 nm et ladite deuxième sous-couche barrière une épaisseur comprise entre 3 nm et 50 nm.

5. Hétérostructure semi-conductrice selon l'une des revendications précédentes, dans laquelle ladite première sous-couche barrière présente une épaisseur comprise entre 3 nm et 15 nm, ladite deuxième sous-couche barrière une épaisseur comprise entre 1 nm et 50 nm et ladite troisième sous-couche barrière présente une épaisseur comprise entre 3 nm et 10 nm.

6. Hétérostructure semi-conductrice selon l'une des revendications précédentes comportant également, entre lesdites couches tampon et d'espacement, une couche épitaxiale (g) réalisée en un matériau semi-conducteur de bande interdite moins large.

7. Hétérostructure semi-conductrice selon la revendication 6 dans laquelle ladite couche épitaxiale est réalisée en In_{y}Ga_{1-y}As, le coefficient stoechiométrique y prenant une valeur comprise entre 0,10 et 0,30.

8. Hétérostructure semi-conductrice selon l'une des revendications 6 ou 7, dans laquelle ladite couche épitaxiale présente une épaisseur comprise entre 1 et 20 nm.

9. Hétérostructure semi-conductrice selon l'une des revendications précédentes, dans laquelle ladite couche tampon est en GaAs.

10. Hétérostructure semi-conductrice selon l'une des revendications précédentes, comprenant aussi une couche de recouvrement (a) déposée sur ou au-dessus de ladite couche barrière.

11. Hétérostructure semi-conductrice selon l'une des revendications précédentes, dans laquelle ledit substrat est en GaAs.

12. Hétérostructure semi-conductrice selon l'une des revendications précédentes, dans laquelle ledit dopage est de type N.

13. Hétérostructure semi-conductrice selon la revendication 16, dans laquelle ledit dopage se présente sous la forme d'un plan de dopage et est réalisé en Si avec une concentration comprise entre 1·10¹² cm⁻² et 5·10¹³ cm⁻².

14. Transistor à effet de champ à haute mobilité électronique - HEMT - réalisé à partir d'une hétérostructure selon l'une des revendications précédentes et comprenant un contact de grille (G) présentant une longueur (Lg) comprise entre 1 et 100 µm et une largeur (W) comprise entre 100 µm et 10 mm.

15. Utilisation d'un transistor selon la revendication 14 à une température inférieure ou égale à 100 K, de préférence inférieure ou égale à 77K et de manière encore préférée inférieure ou égale à 4,2 K.

## Patentansprüche

1. Halbleiterheterostruktur, umfassend:
- ein Substrat (SS);
- eine Pufferschicht (h), welche auf oder über dem Substrat deponiert ist;
- eine Spacerschicht (d, e, f), welche auf oder über der Pufferschicht deponiert ist; und
- eine Barrierenschicht (b, c), welche auf der Spacerschicht deponiert ist;
wobei:
- eine Dotierung (DS) in der Barrierenschicht oder an der Schnittstelle zwischen der Spacerschicht und der Barrierenschicht vorgesehen ist; und
- wobei die Barrierenschicht und Spacerschicht realisiert sind aus einem oder mehreren Halbleitermaterialien, welche eine Bandlücke aufweisen, die größer ist als bei dem Material bzw. den Materialien, welche die Pufferschicht bilden;
- wobei die Barrierenschicht eine erste Barrierensubschicht(c) in Kontakt mit der Spacerschicht und eine zweite Barrierensubschicht(b), welche von der Spacerschicht beabstandet ist, umfasst;
- wobei die zweite Barrierensubschicht (b) eine Bandlücke aufweist, welche größer ist als bei der ersten Barrierensubschicht (c);
**dadurch gekennzeichnet, dass**:
- die Spacerschicht eine erste Spacersubschicht (f), eine zweite Spacersubschicht (e), welche auf oder oberhalb der ersten Subschicht deponiert ist, und eine dritte Spacersubschicht (d), welche auf oder über der zweiten Subschicht und in Kontakt mit der Barrierenschicht deponiert ist, umfasst; und
- die zweite Spacersubschicht (e) eine Bandlücke aufweist, welche größer ist als bei der ersten (f) und dritten (d) Spacersubschicht.

2. Halbleiterheterostruktur nach Anspruch 1, wobei die Barrierenschicht aus einem Aluminium enthaltenden Halbleitermaterial realisiert ist, wobei die zweite Barrierensubschicht einen höheren Aluminiumgehalt aufweist als die erste Barrierensubschicht.

3. Halbleiterheterostruktur nach einem der vorhergehenden Ansprüche, wobei die Barrierenschicht aus ALₓGa₁₋ₓAs realisiert ist und wobei der stöchiometrische Koeffizient x aufweist:
- in der ersten Barrierensubschicht einen Wert, welcher zwischen 0,18 und 0,33 enthalten ist; und
- in der zweiten Barrierensubschicht einen Wert, welcher zwischen 0,34 und 0,5 und bevorzugt zwischen 0,38 und 0,42 enthalten ist.

4. Halbleiterheterostruktur nach einem der vorhergehenden Ansprüche, wobei die ersten Barrierensubschicht eine Dicke aufweist, welche zwischen 3 nm und 10 nm enthalten ist und die zweite Barrierensubschicht eine Dicke aufweist, welche zwischen 3 nm und 50 nm enthalten ist.

5. Halbleiterheterostruktur nach einem der vorhergehenden Ansprüche, wobei die erste Barrierensubschicht eine Dicke aufweist, welche zwischen 3 nm und 15 nm enthalten ist, die zweite Barrierensubschicht eine Dicke aufweist, welche zwischen 1 nm und 50 nm enthalten ist, und die dritte Barrierensubschicht eine Dicke aufweist, welche zwischen 3 nm und 10 nm enthalten ist.

6. Halbleiterheterostruktur nach einem der vorhergehenden Ansprüche, umfassend außerdem, zwischen der Puffer- und Spacerschicht, eine epitaktische Schicht (g), welche aus einem Halbleitermaterial mit geringerer Bandlücke realisiert ist.

7. Halbleiterheterostruktur nach Anspruch 6, wobei die epitaktische Schicht aus In_{y}G_{a-y}As realisiert ist, wobei der stöchiometrische Koeffizient y einen Wert annimmt, welcher zwischen 0,10 und 0,30 enthalten ist.

8. Halbleiterheterostruktur nach einem der Ansprüche 6 oder 7, wobei die epitaktische Schicht eine Dicke aufweist, welche zwischen 1 und 20 nm enthalten ist.

9. Halbleiterheterostruktur nach einem der vorhergehenden Ansprüche, wobei die Pufferschicht aus GaAs ist.

10. Halbleiterheterostruktur nach einem der vorhergehenden Ansprüche, umfassend außerdem eine Deckschicht (a), welche auf oder über der Barrierenschicht deponiert ist.

11. Halbleiterheterostruktur nach einem der vorhergehenden Ansprüche, wobei das Substrat aus GaAs ist.

12. Halbleiterheterostruktur nach einem der vorhergehenden Ansprüche, wobei die Dotierung vom N-Typ ist.

13. Halbleiterheterostruktur nach Anspruch 16, wobei die Dotierung die Form einer Dotierebene aufweist und realisiert ist aus Si mit einer Konzentration, welche zwischen 1·10¹² cm⁻² und 5·10¹³ cm⁻² enthalten ist.

14. Feldeffekttransistor mit hoher Elektronenmobilität - HEMT - realisiert ausgehend von einer Heterostruktur nach einem der vorhergehenden Ansprüche und umfassend ein Kontaktgitter (G) mit einer Länge (Lg), welche zwischen 1 und 100 µm enthalten ist, und einer Breite (W), welche zwischen 100 µm und 10 mm enthalten ist.

15. Verwendung eines Transistors nach Anspruch 14 bei einer Temperatur von kleiner oder gleich 100 K, bevorzugt kleiner oder gleich 77 K, und auf noch bevorzugtere Weise kleiner oder gleich 4,2 K.

## Claims

1. A semiconductor heterostructure comprising:
· a substrate (SS);
· a buffer layer (h) deposited on or over said substrate;
· a spacing layer (d, e, f) deposited on or over said buffer layer; and
a barrier layer (b, c) deposited on said spacing layer;
in which heterostructure:
• doping (DS) is provided in the barrier layer or at the interface between the spacing layer and the barrier layer;
· said barrier and spacing layers are made of one or more semiconductor materials presenting a forbidden band wider than that of the materials constituting said buffer layer;
· said barrier layer comprises a first barrier sublayer (c) in contact with said spacing layer and a second barrier sublayer (b) spaced apart from said spacing layer;
· said second barrier sublayer (b) presents a forbidden band that is wider than the forbidden band of said first barrier sublayer (c).
the heterostructure being **characterized in that**:
· said spacing layer comprises a first spacing sublayer (f), a second spacing sublayer (e) deposited on or over said first spacing sublayer, and a third spacing sublayer (d) deposited on or over said second spacing sublayer and in contact with said barrier layer; and
· said second spacing sublayer (e) presents a forbidden band that is wider than the forbidden bands of said first and third spacing sublayers (f, d).

2. A semiconductor heterostructure according to claim 1, wherein said barrier layer is made of a semiconductor material containing aluminum, said second barrier sublayer presenting an aluminum content that is higher than that of said first barrier sublayer.

3. A semiconductor heterostructure according to any preceding claim, wherein said barrier layer is made of AlₓGa₁₋ₓAs and wherein the stoichiometric coefficient x presents:
· in said first barrier sublayer, a value lying in the range 0.18 to 0.33; and
· in said second barrier sublayer, a value lying in the range 0.35 to 0.5 and preferably in the range 0.38 to 0.42.

4. A semiconductor heterostructure according to any preceding claim, wherein said first barrier sublayer presents a thickness lying in the range 3 nm to 10 nm, and said second barrier sublayer presents a thickness lying in the range 3 nm to 50 nm.

5. A semiconductor heterostructure according to any preceding claim, wherein said first barrier sublayer presents a thickness lying in the range 3 nm to 15 nm, said second barrier sublayer presents a thickness lying in the range 1 nm to 50 nm, and said third barrier sublayer presents a thickness lying in the range 3 nm to 10 nm.

6. A semiconductor heterostructure according to any preceding claim and further including an epitaxial layer (g) between said buffer and spacing layers, the epitaxial layer being made of a semiconductor material having a narrower forbidden band.

7. A semiconductor heterostructure according to claim 6, wherein said epitaxial layer is made of In_{y}Ga_{1-y}As, the stoichiometric coefficient y presenting a value lying in the range 0.10 to 0.30.

8. A semiconductor heterostructure according to claim 6 or claim 7, wherein said epitaxial layer presents a thickness lying in the range 1 nm to 20 nm.

9. A semiconductor heterostructure according to any preceding claim, wherein said buffer layer is made of GaAs.

10. A semiconductor heterostructure according to any preceding claim, also including a covering layer (a) deposited on or over said barrier layer.

11. A semiconductor heterostructure according to any preceding claim, wherein said substrate is made of GaAs.

12. A semiconductor heterostructure according to any preceding claim, wherein said doping is of N type.

13. A semiconductor heterostructure according to claim 16, wherein said doping is in the form of a doping plane and is made of Si at a concentration lying in the range 1×10¹² cm⁻² to 5×10¹³ cm⁻².

14. A high electron mobility field effect transistor (HEMT) made from a heterostructure according to any preceding claim and having a gate contact (G) presenting a length (Lg) lying in the range 1 µm to 100 µm and a width (W) lying in the range 100 µm to 10 mm.

15. The use of a transistor according to claim 14 at a temperature less than or equal to 100 K, preferably less than or equal to 77 K, and in even more preferred manner less than or equal to 4.2 K.
